# EUROPÄISCHE PATENTSCHRIFT

(11) **EP 0 582 213 B1**
(45) Veröffentlichungstag und Bekanntmachung des Hinweises auf die Patenterteilung: **04.09.1996**
(21) Anmeldenummer: 93112120.6
(22) Anmeldetag: 29.07.1993
(51) Int. Cl.: H01L 23/473, H01L 23/40, H01L 25/11

(54) **Spannverband mit Halbleiterzellen und Kühldosen**
Pressure assembly with semi-conductor cells and cooling boxes
Assemblage à pression avec des cellules semi-conductrices et des boîtes de refroidissement

(30) Priorität: 04.08.1992 DE 4225674
(43) Veröffentlichungstag der Anmeldung: 09.02.1994
(73) Patentinhaber: ABB PATENT GmbH, D-68309 Mannheim (DE)
(72) Erfinder: Krämer, Wilhelm, D-69207 Sandhausen (DE)
(74) Vertreter: Rupprecht, Klaus, Dipl.-Ing.

(56) Entgegenhaltungen:
- DE-A- 2 417 031
- DE-A- 3 740 236
- US-A- 4 020 399

## Beschreibung

Die Erfindung bezieht sich auf einen Spannverband mit Halbleiterzellen und Kühldosen und kann beispielsweise bei wassergekühlten Stromrichtern für elektrische Schienenfahrzeuge eingesetzt werden.

Es ist in der Stromrichtertechnik allgemein bekannt und üblich, Stromrichter mit Halbleiterzellen und Kühldosen zum Abführen der in den Halbleiterzellen während des Betriebes produzierten Verlustleistungswärme in Spannverbänden zusammenzufassen, wobei mit Hilfe relativ großer Preßkräfte eine Druckkontaktierung der Halbleiterzellen erfolgt. Dabei tritt das Problem der Lagerung des Spannverbandes auf, wobei in diesem Zusammenhang das thermische Ausdehnungsverhalten des Spannverbandes während des Betriebes und die hieraus resultierenden Kräfte bzw. Bewegungen zu berücksichtigen sind. DE-A-3 740 236 offenbart einen Konventionellen Spannverband mit Halbleiterzellen und Kühldosen.

Der Erfindung liegt die Aufgabe zugrunde, einen Spannverband mit Halbleiterzellen und Kühldosen anzugeben, der unter Berücksichtigung des thermischen Ausdehnungsverhaltens einfach gelagert ist.

Diese Aufgabe wird in Verbindung mit den Merkmalen des Oberbegriffes erfindungsgemäß durch die im Kennzeichen des Anspruchs 1 angegebenen Merkmale gelöst.

Die mit der Erfindung erzielbaren Vorteile bestehen insbesondere darin, daß aufgrund der Verwendung von Hydraulikverbindern zwischen Kühldosen und Kühlflüssigkeitsleitung zur Lagerung des Spannverbandes eigene Lager inklusive Lagerstützer im Spannverband nicht mehr notwendig sind, d.h. es ergibt sich eine Einsparung von Baukomponenten und damit eine Gewichts-, Raumbedarfs- und Kostenreduzierung. Thermische Ausdehnungen des Spannverbandes während des Betriebes stellen kein Problem für die Lagerung dar, da die abgedichteten Anschlüsse zwischen Hydraulikverbindern und Kühlflüssigkeitsleitung eine seitliche Bewegung des Spannverbandes erlauben, ohne daß dabei zusätzliche mechanische Spannungen bezüglich der Lagerung auftreten. Da auch die elektrische Kontaktierung der Hauptanschlüsse der Halbleiterzellen des Spannverbandes seitliche Bewegungen erlauben, wird ingesamt ein Spannverband vorgeschlagen, bei dem thermische Ausdehnungen während des Betriebes keinerlei negativen Einflüssen auf die Lagerung, die hydraulischen Anschlüsse und die elektrische Kontaktierung haben.

Vorteilhafte Ausgestaltungen der Erfindung sind in den Unteransprüchen gekennzeichnet.

Die Erfindung wird nachstehend anhand der in der Zeichnung dargestellten Ausführungsbeispiele erläutert. Es zeigen:
- Figur 1: einen Spannverband inklusive hydraulischem Anschluß,
- Figur 2: einen Spannverband inklusive elektrischer Steckverbinder
- Figur 3: eine Loslagerung einer Kühldose eines Spannverbandes,
- Figur 4: eine Festlagerung einer Kühldose eines Spannverbandes,
- Figur 5: eine Detailansicht der Kugellinearlagerung,
- Figur 6: eine Detailansicht der Dichtringanordnung.

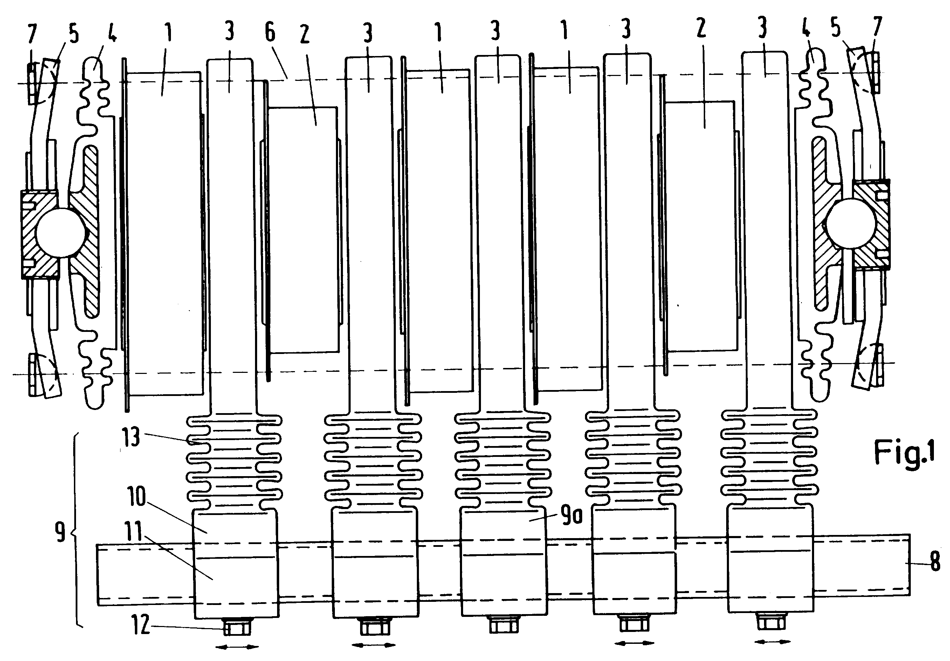

In Figur 1 ist ein Spannverband inklusive hydraulischem Anschluß dargestellt. Der Spannverband weist beispielsweise drei Thyristoren 1, zwei Dioden 2 und fünf Kühldosen 3 (Flüssigkeitskühlkörper) auf, wobei jeweils zwischen zwei Halbleiterzellen eine Kühldose angeordnet ist. An beiden Enden des Spannverbandes befinden sich Endstützer 4 mit integrierten Druckplatten. Gegen die Endstützer 4 drücken Spannfedern 5 (Tellerfedern), die über Spannstäbe 6 miteinander verbunden sind, wobei Spannschrauben 7 zur Verschraubung der Spannstäbe 6 und damit zur Einstellung der auf den Spannverband wirkenden Preßkraft dienen.

Die Kühldosen 3 sind über Hydraulikverbinder 9 mit einer Kühlflüssigkeitsleitung 8 verbunden, wobei die Hydraulikverbinder neben der hydraulischen Anbindung der Kühldosen an einen externen Kühlflüssigkeitskreislauf die mechanische Lagerung des Spannverbandes bewerkstelligen. Jeder Hydraulikverbinder 9 einer Kühldose 3 weist zwei Anschlußstücke 10, 11 auf, die um die Kühlflüssigkeitsleitung 8 greifen und über Schraubverbindungen 12 miteinander verbunden sind. Das Anschlußstück 10 führt über ein Rohr 13 zur Kühldose. Über Öffnungen in der Kühlflüssigkeitsleitung 8 und im Anschlußstück 10 wird ein Kühlflüssigkeitspfad gebildet, der über das Rohr 13 zur Kühldose 3 führt.

Die hydraulische Abdichtung des gebildeten Kühlflüssigkeitspfades erfolgt über einen Dichtring, der in eine entsprechende Nut des Anschlußstücks 10 eingelegt ist und der die Öffnungen in der Kühlflüssigkeitsleitung 8 und im Anschlußstück 10 umfaßt. Wesentlich dabei ist, daß diese hydraulische Abdichtung seitliche Bewegungen des Hydraulikverbinders 9 auf der Kühlflüssigkeitsleitung 8 ermöglicht. Hierdurch werden thermisch bedingte Ausdehnungen des Spannverbandes während des Betriebes aufgefangen, ohne daß dies zu zusätzlichen mechanischen Spannungen bezüglich der Lagerung führt. Die Anschlußstücke 10, 11 sind demgemäß über die Schraubverbindungen 12 derart auf der Kühlflüssigkeitsleitung 8 zu befestigen, daß einerseits die seitliche thermische Ausdehnungsbewegung ermöglicht wird, andererseits jedoch eine hydraulisch dichte und mechanisch ausreichend stabile, insbesondere rüttelsichere Lagerung des Spannverbandes sicherzustellen ist.

Zweckmäßig ist zur Bildung eines Festpunktes der Lagerung der mittlere Hydraulikverbinder eines Spannverbandes, in Figur 1 mit 9a bezeichnet, fest auf der Kühlflüssigkeitsleitung 8 montiert, so daß an diesem Festpunkt keine seitliche Bewegung ermöglicht wird, während die übrigen Hydraulikverbinder seitlich "wandern" können. Bei einer derartigen Lagerung sind die seitlichen Bewegungen der einzelnen Hydraulikverbinder am geringsten. Selbstverständlich sind je nach konstruktiven Gegebenheiten auch andere Varianten bei der Festpunktbildung der Lagerung möglich.

Bei der hydraulischen Anbindung der Kühldose 3 an einen externen Kühlflüssigkeitskreislauf sind verschiedende Varianten einsetzbar. Beispielsweise kann die Kühlflüssigkeitsleitung 8 intern geteilt sein und einen Vorlauf- und einen Rücklaufkanal für die Kühlflüssigkeit aufweisen. Die Anschlußstücke 10 und die Rohre 13 sind dementsprechend auszugestalten, d.h. es sind je ein Vorlauf- und ein Rücklaufkanal mit den entsprechenden Anschlußöffnungen innerhalb der Anschlußstücke 10 und Rohre 13 auszubilden. Es ist auch möglich, zwei getrennte Kühlflüssigkeitsleitungen 8 vorzusehen, wobei eine Leitung den Vorlauf- und eine Leitung den Rücklaufkanal für die Kühlflüssigkeit bildet.

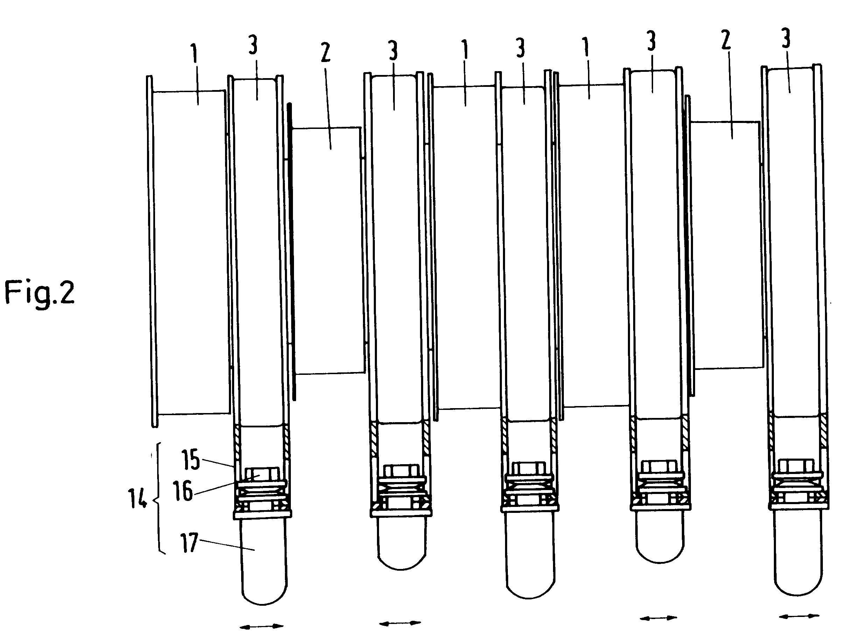

In Figur 2 ist ein Spannverband inklusive elektrischer Steckverbinder dargestellt. Dabei handelt es sich um den in Figur 1 gezeigten Spannverband, jedoch sind die Hydraulikverbinder und die Kühlflüssigkeitsleitung nicht gezeigt, um die Übersichtlichkeit der Darstellung zu erhöhen.

Wie zu erkennen ist, erfolgt die elektrische Kontaktierung der Hauptanschlüsse der Halbleiterzellen über einzelne elektrische Steckverbinder 14, wobei jeder Steckverbinder 14 aus einem oder mehreren Kontaktierungsblechen 15, einer Schraubverbindung 16 und einem Multikontakt 17 besteht. Die Kontaktierungsbleche 15 sind zwischen den Hauptflächen der Halbleiterzellen und Kühldosen 3 angeordnet und behindern die Wärmeübertragung zwischen Halbleiterzelle und Kühldose nicht, da sie aus einem thermisch und elektrisch gut leitenden Material, vorzugsweise Kupfer, bestehen. Die Multikontakte 17, die mittels der Schraubverbindungen 16 mit den Kontaktierungsblechen 15 verbunden sind, greifen in nicht dargestellte elektrische Gegenkontakte derart ein, daß thermisch bedingte seitliche Bewegungen des Spannverbandes ermöglicht werden, ohne daß dabei die elektrische Kontaktierung behindert wird.

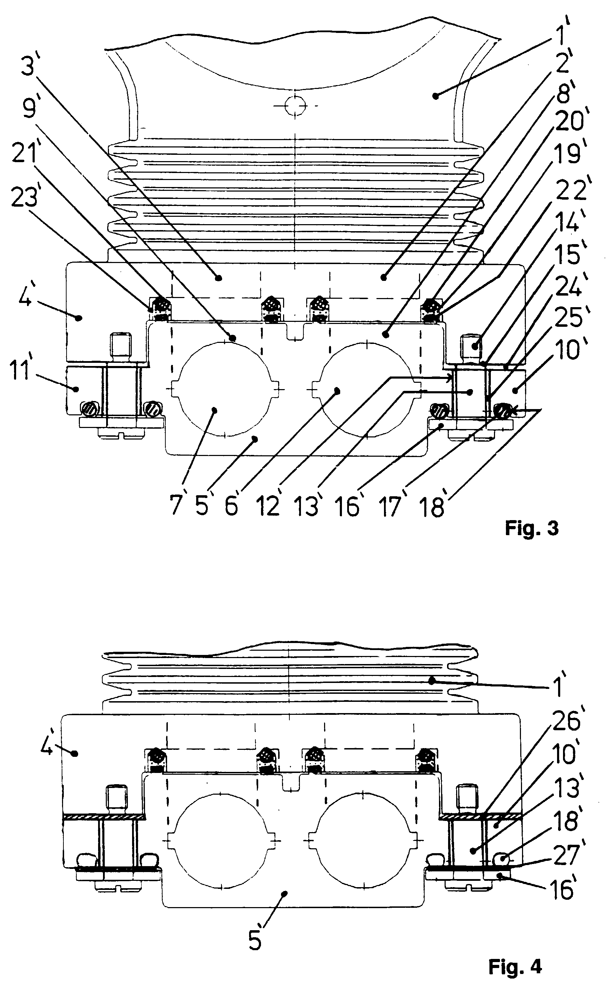

In Figur 3 ist eine Loslagerung einer Kühldose eines Spannverbandes dargestellt, wie sie vorteilhaft bei allen Kühldosen eines Spannverbandes mit Ausnahme der mittleren Kühldose eingesetzt wird. Eine Kühldose 1' mit hydraulischen Anschlüssen 2', 3' (Kühlflüssigkeitsvorlauf und -rücklauf) ist über ihren Kühldosenflansch 4' an einer Kühlflüssigkeitsverteilerleitung 5' befestigt. Diese Leitung 5' verbindet die einzelnen Kühldosen eines Spannverbandes mit einem Rückkühler und weist hierzu einen Vorlaufkanal 6' und einen Rücklaufkanal 7' auf. Die Kühlflüssigkeit tritt über eine Anschlußöffnung 8' (Langloch) des Kanals 6' in den hydraulischen Anschluß 2' ein, durchströmt die Kühldose 1' und tritt vom hydraulischen Anschluß 3' über eine Anschlußöffnung 9' (Langloch) in den Kanal 7' ein.

Zur Schraubbefestigung der Kühldose 1' auf der Kühlflüssigkeitsverteilerleitung 5' ist letztere mit Verteilerleitungsflanschen 10', 11' versehen, welche Bohrungen 12' aufweisen. Die Schraubbefestigung erfolgt, indem durch die Bohrungen 12' gesteckte Schrauben 13' in Gewindebohrungen 14' des Kühldosenflansches 4' eingreifen und verschraubt werden.

Die Verteilerleitungsflansche 10', 11' sind parallel zur Hauptachse der Leitung 5' zu beiden Seiten der Bohrungen 12' mit hinterschnittenen Nuten 18' versehen, die zur Führung von eingelegten Kugeln 17' dienen. Die Schrauben 13' drücken über zwischengelegte Unterlegscheiben 16' gegen die geringfügig aus der Nut 18' ragenden Kugeln 17'. Die abgestuften Schultern 15' der Schrauben 13' pressen gegen den Flansch 4' und es bildet sich ein Spalt 24' mit definierter Spaltbreite zwischen Kühldosenflansch 4' und Verteilerleitungsflansch 10'/11' aus.

Zur hydraulischen Abdichtung der Flüssigkeitsübergänge hydraulischer Anschluß 2'/Anschlußöffnung 8' bzw. hydraulischer Anschluß 3'/Anschlußöffnung 9' sind jeweils zwei Dichtringe 20', 22' vorgesehen, die in Stützringen 19' gehalten werden. Dichtring 20' greift in eine den hydraulischen Anschluß der Kühldose umschließende Nut 21' im Kühldosenflansch 4', die ein V-förmiges Profil aufweist, wodurch eine Zentrierung des Dichtringes 20' erzielt wird. Dichtring 22' wird gegen die Kühlflüssigkeitsverteilerleitung 5' gepreßt und umschließt dort die Anschlußöffnung. Die Lage des Stützringes 19' innerhalb dieser hydraulischen Abdichtungsanordnung ist derart, daß sich rundum ein Spalt 23' definierter Spaltbreite zwischen Stützring 19' und der begrenzenden inneren Mantelfläche des Kühldosenflansches 4' ausbildet. Ein weiterer für die Linearverschiebefunktion wichtiger Ringspalt 25' befindet sich zwischen Schraube 13' und begrenzender Wandung der Bohrung 12'.

Durch die vorstehend erläuterte rüttelsichere Konfiguration ergibt sich ein mit Spaltabstand auf der Kühlflüssigkeitsverteilerleitung 5' montierter Kühldosenflansch 4' mit einer inneren Schwenkdichtung 20'/22' für die Linearausdehnung und Rückverformung bei Temperaturänderung der Halbleiter und Kühldosen, welche nicht rutscht, sondern mit geringen Abrollvorgängen leichtgängig schwenkt. Hierzu trägt vorteilhaft die Kugellinearlagerung 16'/17' bei. Insgesamt ergibt sich eine Axialschwenkdichtung mit Radialarretierung auf der Kühlflüssigkeitsverteilerleitung. Vorteilhaft tritt zwischen allen gegen die Elastizität der Dichtung gegeneinander gedrückten Bauteilen lediglich Rollreibung auf. Die Istmaßtoleranzen der Bauteile brauchen nicht ausgeglichen zu werden, denn dieser Ausgleich erfolgt automatisch nach dem Spannen des Spannverbandes.

In Figur 4 ist eine Festlagerung einer Kühldose eines Spannverbandes dargestellt, wie sie vorteilhaft bei der mittleren Kühldose eines Spannverbandes eingesetzt wird. Im Unterschied zur in Figur 1 erläuterten Loslagerung sind in die Nuten 18' keine Kugeln eingelegt. Der bei Loslagerung durch die aus der Nut 18 ragenden Kugeln 17' entstehende Spaltabstand fehlt bei der Festlagerung. Deshalb wird bei Festlagerung eine zusätzliche Unterlegscheibe 27' zwischen Verteilerleitungsflansch 10', 11' und Unterlegscheibe 16' eingelegt, deren Breite dem vorstehend erwähnten Spaltabstand entspricht. Da bei der Festlagerung jegliches Schwenken der Kühldose unerwünscht ist, wird der Spalt 24' beseitigt, indem zwischen Kühldosenflansch 4' und Verteilerleitungsflansch 10', 11' eine Unterlegscheibe 26' eingelegt wird. Somit ergibt sich nach Montage der Schraube 13' eine starre Befestigung der Kühldose 1' auf der Kühlflüssigkeitsverteilerleitung 5' (Festdichtung), wobei die Achsflucht zu den Kühldosen bei Festlagerung und Loslagerung gleich ist.

Vorteilhaft ist, daß im wesentlichen die gleichen Bauteile für die Loslagerung und die Festlagerung verwendet werden. Justierarbeiten bei der Montage entfallen.

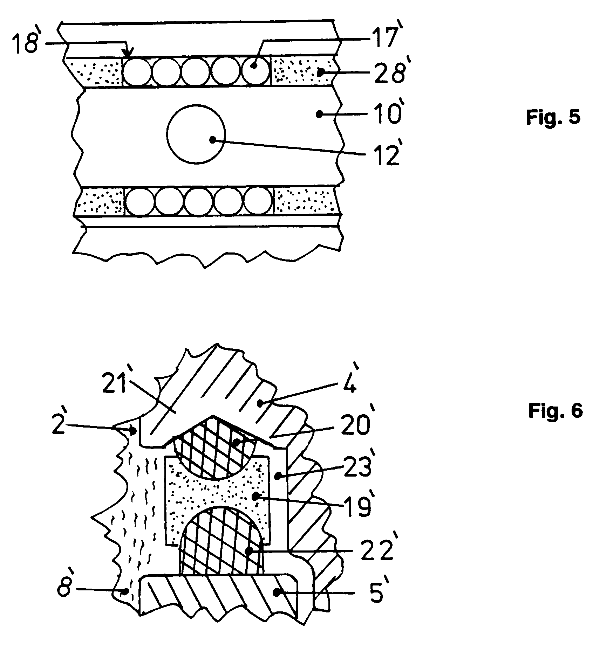

In Figur 5 ist eine Detailansicht der Kugellinearlagerung (vergrößert) dargestellt. Wie zu erkennen ist, befinden sich mehrere Kugeln 17' in den Nuten 18' zu beiden Seiten der Bohrung 12' im Verteilerleitungsflansch 10'. Um ein Wegrollen und Herausfallen der Kugeln aus der Nut zu unterbinden, wird der seitliche Bewegungsraum der Kugeln durch in die Nuten eingelegte Füllstäbe 28' aus einem weichen, elastischen Material begrenzt. Jeweils an den Enden der Nuten verhindern Abschlußstreifen ein Verschieben der Linearlagerungen.

In Figur 6 ist eine Detailansicht der Dichtringanordnung (vergrößert) dargestellt. Beide Dichtringe 20', 22' werden vom Stützring 19' gehalten. Die Nut 21' im Kühldosenflansch 4' zentriert Dichtring 20', während Dichtring 22' auf der Kühlflüssigkeitsverteilerleitung 5' aufsitzt. Durch die Zentrierung wird die Einhaltung des seitlichen Abstandes 23' zwischen Stützring 19' und Kühldosenflansch 4' gewährleistet, der zur Ermöglichung der Schwenkbewegung erforderlich ist. Die Kühlflüssigkeitsströmung über den hydraulischen Anschluß 2' der Kühldose und die Anschlußöffnung 8' der Kühlflüssigkeitsverteilerleitung ist angedeutet.

## Patentansprüche

1. Spannverband mit Halbleiterzellen und Kühldosen, dadurch gekennzeichnet, daß die Lagerung des Spannverbandes über Hydraulikverbinder (9) erfolgt, die eine hydraulische Anbindung der Kühldosen an eine Kühlflüssigkeitsleitung (8) bewerkstelligen, wobei abgedichtete hydraulische Anschlüsse zwischen den Hydraulikverbindern (9) und der Kühlflüssigkeitsleitung (8) vorgesehen sind, die eine seitliche Bewegung der Hydraulikverbinder (9) auf der Kühlflüssigkeitsleitung (8) ermöglichen.

2. Spannverband nach Anspruch 1, dadurch gekennzeichnet, daß die elektrische Kontaktierung der Halbleiterzellen (1,2) des Spannverbandes über elektrische Steckverbinder (14) mit Multikontakten (17) erfolgt, die eine seitliche Bewegung in einem elektrischen Gegenkontaktstück ermöglichen.

3. Spannverband nach Anspruch 1 und/oder 2, dadurch gekennzeichnet, daß ein Hydraulikverbinder (9) über zwei miteinander verbindbare Anschlußstücke (10,11) über die Kühlflüssigkeitsleitung (8) greift, wobei das eine Anschlußstück (10) über ein Rohr (13) mit der Kühldose (3) verbunden ist.

4. Spannverband nach Anspruch 3, dadurch gekennzeichnet, daß die hydraulische Abdichtung zwischen den für den Kühlflüssigkeitstransport vorgesehenen Öffnungen in der Kühlflüssigkeitsleitung (8) und dem Anschlußstück (10) des Hydraulikverbinders (9) über einen Dichtring erfolgt, der in eine Nut im Anschlußstück (10) eingreift.

5. Spannverband nach einem der Ansprüche 1 bis 4, gekennzeichnet durch eine Axialschwenkdichtung, bei der Spalten (23',24',25') mit jeweils definierter Spaltbreite zwischen den Dichtungen (20',22') und Seitenwandungen von Kühldosenflanschen (4') und Verteilerleitungsflanschen (10',11') der Kühlflüssigkeitsverteilerleitung (5'), zwischen den Flanschen und zwischen Bauteilen der Schraubbefestigung vorgesehen sind, wobei die Spalten ein axiales Schwenken bei der Loslagerung erlauben.

6. Spannverband nach Anspruch 5, dadurch gekennzeichnet, daß die Dichtungen jeden hydraulischen Anschlusses aus mindestens zwei übereinanderliegenden Dichtringen (20',22') bestehen.

7. Spannverband nach Anspruch 6, dadurch gekennzeichnet, daß ein Stützring (19') zur Arretierung der Dichtringe (20',22') vorgesehen ist.

8. Spannverband nach einem der Ansprüche 5 bis 7, gekennzeichnet durch ein V-förmiges Profil (21') im Kühldosenflansch (4') zur Zentrierung der Dichtung.

9. Spannverband nach einem der Ansprüche 5 bis 8, gekennzeichnet durch eine Kugellinearlagerung bei der Loslagerung, wobei in Nuten (18') des Verteilerleitungsflansches (10',11') geführte Kugeln (17') vorgesehen sind, gegen die die Schraubverbindung (13',16') drückt.

10. Spannverband nach einem der Ansprüche 5 bis 8, dadurch gekennzeichnet, daß die Spalten (23',24',25') bei der Festlagerung durch eingelegte Unterlegscheiben (26',27') beseitigt sind.

## Claims

1. Pressure assembly with semiconductor cells and cooling boxes, characterized in that the bearing of the pressure assembly is performed via hydraulic connectors (9) which accomplish a hydraulic connection of the cooling boxes to a cooling liquid line (8), sealed hydraulic connections between the hydraulic connectors (9) and the cooling liquid line (8) being provided which permit a lateral movement of the hydraulic connectors (9) on the cooling liquid line (8).

2. Pressure assembly according to Claim 1, characterized in that the electric contacting of the semiconductor cells (1, 2) of the pressure assembly is performed via electric plug-in connectors (14) with multicontacts (17) which permit a lateral movement in a mating electric contact piece.

3. Pressure assembly according to Claim 1 and/or 2, characterized in that one hydraulic connector (9) grips around the cooling liquid line (8) via two interconnectable connecting pieces (10, 11), one connecting piece (10) being connected to the cooling box (3) via a tube (13).

4. Pressure assembly according to Claim 3, characterized in that the hydraulic sealing between the openings, provided for the transport of cooling liquid, in the cooling liquid line (8) and the connecting piece (10) of the hydraulic connector (9) is performed via a sealing ring which engages in a groove in the connecting piece (10).

5. Pressure assembly according to one of Claims 1 to 4, characterized by an axial swivel seal in which gaps (23', 24', 25') with a respectively defined gap width are provided between the seals (20', 22') and side walls of cooling box flanges (4') and distributor line flanges (10', 11') of the cooling liquid distributor line (5'), between the flanges and between components of the screw fastening, the gaps permitting axial swivelling in the case of floating bearing.

6. Pressure assembly according to Claim 5, characterized in that the seals of each hydraulic connection consist of at least two sealing rings (20', 22') situated one above the other.

7. Pressure assembly according to Claim 6, characterized in that a support ring (19') is provided for the purpose of locking the sealing rings (20', 22').

8. Pressure assembly according to one of Claims 5 to 7, characterized by a V-shaped profile (21') in the cooling box flange (4') for the purpose of centring the seal.

9. Pressure assembly according to one of Claims 5 to 8, characterized by a linear ball bearing in the floating bearing, balls (17') being provided which are guided in grooves (18') of the distributor line flange (10', 11') and against which the screwed connection (13', 16') presses.

10. Pressure assembly according to one of Claims 5 to 8, characterized in that the gaps (23', 24', 25') are eliminated in the case of locating bearing by inserted washers (26', 27').

## Revendications

1. Ensemble de cellules semi-conductrices et de boîtes de refroidissement assemblé par serrage, caractérisé par le fait que l'ensemble est supporté par des connecteurs hydrauliques (9) qui réalisent une liaison hydraulique entre les boîtes de refroidissement et une conduite (8) de liquide de refroidissement, des raccords hydrauliques étanches qui permettent un déplacement latéral des connecteurs hydrauliques (9) sur la conduite (8) de liquide de refroidissement étant prévus entre les connecteurs hydrauliques (9) et la conduite (8) de liquide de refroidissement.

2. Ensemble selon la revendication 1, caractérisé par le fait que le branchement électrique des cellules semi-conductrices (1, 2) de l'ensemble est réalisé au moyen de connecteurs (14) électriques enfichables à contacts multiples (17), qui autorisent un déplacement latéral dans une pièce de contact électrique conjuguée.

3. Ensemble selon la revendication 1 et/ou la revendication 2, caractérisé par le fait qu'un connecteur hydraulique (9) entoure la conduite (8) de liquide de refroidissement par deux éléments de raccord (10, 11) pouvant être reliés l'un à l'autre, l'un des éléments de raccord (10) communiquant avec la boîte de refroidissement (3) par l'intermédiaire d'un tube (13).

4. Ensemble selon la revendication 3, caractérisé par le fait que l'étanchéité hydraulique entre les ouvertures prévues dans la conduite (8), pour le passage du liquide de refroidissement, et l'élément de raccord (10) du connecteur hydraulique (9) est réalisée au moyen d'un joint annulaire qui pénètre dans une gorge dans l'élément de raccord (10).

5. Ensemble selon l'une des revendications 1 à 4, caractérisé par un joint oscillant axial, dans lequel des espaces (23', 24', 25') de largeur définie sont prévus entre les joints (20', 22') et des parois latérales de brides (4') de boîtes de refroidissement et de brides (10', 11') de conduite (5') de distribution de liquide de refroidissement, entre les brides et entre des composants de l'assemblage vissé, les espaces permettant un pivotement axial lorsque l'ensemble n'est pas serré.

6. Ensemble selon la revendication 5, caractérisé par le fait que les joints de chaque branchement hydraulique sont formés d'au moins deux joints annulaires (20', 22') disposés l'un au-dessus de l'autre.

7. Ensemble selon la revendication 6, caractérisé par le fait qu'il est prévu une bague d'appui (19') pour tenir les joints annulaires (20', 22').

8. Ensemble selon l'une des revendications 5 à 7, caractérisé par un profil en V (21') dans la bride (4') de boîte de refroidissement pour le centrage du joint.

9. Ensemble selon l'une des revendications 5 à 8, caractérisé par un montage sur glissières à billes à l'état non serré, des billes (17') qui sont guidées dans des gorges (18') de la bride (10', 11') de conduite de distribution et sur lesquelles la liaison par vis agit étant prévues.

10. Ensemble selon l'une des revendications 5 à 8, caractérisé par le fait que les espaces (23', 24', 25') sont neutralisés par l'insertion de rondelles (26', 27') à l'état serré.
